# EUROPEAN PATENT APPLICATION

(11) **EP 4 756 862 A1**
(43) Date of publication of application: **10.06.2026**
(21) Application number: 24848368.7
(22) Date of filing: 02.08.2024
(51) Int. Cl.: H01J 37/32

(54) **PLASMA ETCHING DEVICE, ETCHING MACHINE, FOCUS RING AND JACKING STRUCTURE FOR FOCUS RING**

(30) Priority: 03.08.2023 CN 202310976696
(71) Applicant: Jiangsu Leuven Instruments Co. Ltd, Xuzhou, Jiangsu 221300 (CN)
(72) Inventor: YIN, Gehua, Xuzhou, Jiangsu 221300 (CN); LIU, Haiyang, Xuzhou, Jiangsu 221300 (CN); LIU, Xiaobo, Xuzhou, Jiangsu 221300 (CN); XU, Yueyue, Xuzhou, Jiangsu 221300 (CN); CHE, Dongchen, Xuzhou, Jiangsu 221300 (CN); HU, Dongdong, Xuzhou, Jiangsu 221300 (CN); SHI, Xiaoli, Xuzhou, Jiangsu 221300 (CN); XU, Kaidong, Xuzhou, Jiangsu 221300 (CN)
(74) Representative: Eisenführ Speiser
(86) International application number: PCT/CN2024/109354
(87) International publication number: WO 2025/026414

(57) **Abstract**

A plasma etching device, an etching machine, a focus ring (10) and a jacking structure for the focus ring (10). The focus ring (10) comprises a plurality of ring bodies which are stacked; the ring bodies are arranged independent of each other; and the axial dimension of the ring body (1) located on the uppermost layer is greater than the allowed maximum jacking height of the focus ring (10). According to the split focus ring (10), the ring bodies can all be jacked during use, so that a large space below the focus ring (10) after the whole original focus ring (10) is jacked is divided into a plurality of small spaces by means of the ring bodies; and the small spaces are connected only by means of fine gaps between structures, and the concentration and activity of charged particles of plasmas in the small spaces are limited, thereby achieving the purposes of preventing arc discharge and avoiding ignition marks or the fragmentation of the focus ring (10).

## Description

The present application claims priority to Chinese Patent Application No. 202310976696.0, titled "PLASMA ETCHING DEVICE, ETCHING MACHINE, FOCUS RING AND JACKING STRUCTURE FOR FOCUS RING", filed on August 3, 2023 by the applicant "JIANGSU LEUVEN INSTRUMENTS CO., LTD.", which is incorporated herein by reference in its entirety.

### FIELD

The present application relates to the technical field of semiconductor processing equipment, and in particular to a plasma etching device, etch equipment, a focus ring, and a jacking structure for the focus ring.

### BACKGROUND

With the development of semiconductor devices, precision of wafer patterning keeps increasing, resulting gradual emergence of a series of dry etching technologies. Among them, inductively coupled plasma (ICP) etching, as a plasma etching technology for fabricating micro- and nano-structures, offers advantages such as high etching rate, high selectivity, high anisotropy, minimal etching damage, high controllability of etch profiles, and excellent smoothness of etched surfaces, and is therefore widely applied at present.

In an ICP device, etching is performed in a vacuum reaction chamber. An electrostatic chuck is disposed on a base at a central part of the vacuum reaction chamber. A wafer is disposed on an upper surface of the electrostatic chuck, and a focus ring is mounted around the wafer to change distribution and morphology of a plasma sheath in a peripheral region of the wafer.

The focus ring, since it is continuously exposed to plasma generated from etching gas, experiences erosion of its upper surface material, resulting in a gradual decrease in its height. The decrease in the height of the focus ring may cause a series of variations in etching parameters. This may lead to a serious consequence that an etching path in the peripheral region of the wafer is tilted, compromising etching uniformity. In established conventional technologies, jacking up the focus ring to compensate for the amount of erosion has proven to be an effective method.

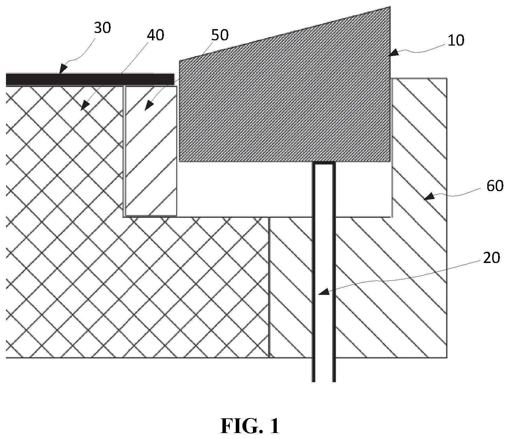

After the focus ring is jacked up, a space is formed beneath the focus ring, as shown in FIG. 1. As processing continues, the focus ring is raised progressively, and the space beneath the focus ring keeps expanding. This, in turn, introduces a new issue: an excessive space beneath the focus ring is highly prone to arc discharge, which generates intense heat instantaneously, thereby leading to ignition marks on the surface of the focus ring and even fragmentation of the focus ring.

### SUMMARY

A first object of the present application is to provide a focus ring, which can prevent the occurrence of arc discharge in an excessive space beneath a focus ring after it is jacked up, thereby avoiding ignition marks or fragmentation of the focus ring.

A second object of the present application is to provide a focus-ring jacking structure for the focus ring as described above, as well as a plasma etching device and etch equipment having the focus ring and the focus-ring jacking structure as described above.

To achieve the above objects, following technical solutions are provided according to the present application.

A focus ring includes multiple ring bodies that are stacked and arranged independently of one another. An uppermost ring body of the multiple ring bodies has an axial dimension greater than a maximum height by which the focus ring is jacked up.

Optionally, the axial dimension of the uppermost ring body is greater than an axial dimension of each of the remaining ring bodies.

Optionally, the axial dimensions of the remaining ring bodies except the uppermost ring body are equal to each other.

Optionally, mating surfaces between every two adjacent ring bodies are annular planar surfaces or surfaces respectively provided with a protrusion and a recess.

Optionally, the mating surfaces between every two adjacent ring bodies are annular planar surfaces perpendicular to an axis of the ring bodies.

Optionally, mating surfaces between every two adjacent ring bodies are curved surfaces; or, mating surfaces between every two adjacent ring bodies are zigzag surfaces; or, pairs of mating surfaces between adjacent ring bodies are in a combination of at least two of following configurations: a pair of planar surfaces, a pair of curved surfaces, and a pair of zigzag surfaces.

Optionally, one of mating surfaces between every two adjacent ring bodies includes a first annular boss and a first annular groove that are alternately arranged along a radial direction of the ring bodies, and the other of the mating surfaces between the two adjacent ring bodies includes a second annular boss and a second annular groove that are alternately arranged along the radial direction of the ring bodies. The first annular boss is received in the second annular groove, and the second annular boss is received in the first annular groove.

Optionally, each of mating surfaces between every two adjacent ring bodies include multiple annular abutment surfaces arranged along a radial direction of the ring bodies with one nested in another. The annular abutment surfaces are sequentially arranged along an axial direction of the ring bodies and are spaced apart in the axial direction of the ring bodies to form a stepped shape.

Optionally, the uppermost ring body is made of one of SiO₂, Si, SiC and Y₂O₃, and each of the remaining ring bodies is made of SiO₂ or Al₂O₃.

A focus-ring jacking structure for jacking up the focus ring as described in any one of the above solutions is provided. The focus-ring jacking structure includes a driving part and multiple actuation parts. The driving part is drivingly connected to the actuation parts. The actuation parts are arranged in one-to-one correspondence with the ring bodies of the focus ring. The driving part of the focus-ring jacking structure is configured to drive the actuation parts to jack up the respective ring bodies of the focus ring by respective predetermined heights according to a predetermined instruction.

Optionally, the focus-ring jacking structure includes a jacking pin member, a multi-ratio transmission mechanism, a positioning member, and a driving module.

The jacking pin member includes multiple jacking pins that are drivingly connected to the respective ring bodies of the focus ring.

The multi-ratio transmission mechanism includes a multi-ratio plate and transmission rods. The multi-ratio plate is provided with transmission structures that are drivingly coupled with the respective transmission rods in one-to-one correspondence. The transmission rods are drivingly connected to the respective jacking pins. Ends of the transmission rods away from the jacking pins are coupled with the respective transmission structures via physical contact. Transmission ratios of the transmission structures decrease proportionally according to an arrangement order of the respective ring bodies from top to bottom within the focus ring.

The positioning member is configured to guide and position the jacking pins and/or the transmission rods to allow the jacking pins to move in both directions along an axial direction of the focus ring.

The driving module is configured to drive the multi-ratio plate to move in both directions along a predetermined direction.

Optionally, the transmission structures are configured as multi-ratio notches. A follower shaft is disposed at a bottom part of each transmission rod. An axis of each follower shaft intersects with an axis of the respective transmission rod. The follower shafts are slidably coupled with respective ones of the multi-ratio notches. A connecting line is defined between two ends of each notch of the multi-ratio notches, and angles between the respective connecting lines and a horizontal plane decrease proportionally according to the arrangement order of the respective ring bodies from top to bottom within the focus ring.

Optionally, the positioning member is provided with guide holes and guide grooves in communication with the respective guide holes. The transmission rods are slidably coupled with the respective guide holes. The follower shafts extend out of the respective guide grooves to be coupled with respective ones of the multi-ratio notch via physical contact.

Optionally, the transmission structures are configured as multi-ratio inclined surfaces. Angles between respective ones of the multi-ratio inclined surfaces and the horizontal plane decrease proportionally according to the arrangement order of the respective ring bodies from top to bottom within the focus ring.

Optionally, the focus-ring jacking structure further includes a fixed seat. The multi-ratio plate is disposed on the fixed seat and is movable in both directions along a direction perpendicular to the axial direction of the focus ring.

Optionally, a slider is disposed on one of the fixed seat and the multi-ratio plate, and a guide rail is disposed on the other of the fixed seat and the multi-ratio plate. The slider is slidably coupled with the guide rail to allow the multi-ratio plate to be slidably connected to the fixed seat.

Optionally, the focus-ring jacking structure includes a jacking pin member and a driving module.

The jacking pin member includes a jacking seat and multiple jacking pins disposed on the jacking seat and corresponding to the respective ring bodies of the focus ring. Clearances between the jacking pins and the respective ring bodies increase in arithmetic progression according to an arrangement order of the respective ring bodies from top to bottom within the focus ring.

The driving module is drivingly connected to the jacking seat through a transmission rod to drive the jacking seat to move in both directions along an axial direction of the focus ring.

Optionally, the transmission rod includes a rod body, a fixed flange and a bellows. The fixed flange is configured to be fixedly connected to etch equipment in a sealing manner. The rod body extends through the fixed flange and is drivingly connected to the jacking pin member. Both ends of the bellows are respectively connected to the fixed flange and a bottom seat of the rod body in a sealing manner.

Optionally, the jacking pins are arranged circumferentially around an axis of the focus ring and are spaced apart from each other.

Optionally, the driving module is a piston cylinder; or, the driving module is a linear motor; or, the driving module includes a rotary motor and a transmission component.

Optionally, the focus-ring jacking structure further includes positioning sleeve shafts configured to be fixedly connected to etch equipment and to guide and position the respective jacking pins.

Etch equipment includes the focus ring according to any one of the above solutions and the focus-ring jacking structure according to any one of the above solutions.

A plasma etching device includes the etch equipment as described above.

It can be known from the above technical solutions that a focus ring is provided according to the present application, which includes multiple ring bodies stacked and arranged independently of one another. The axial dimension of the uppermost ring body is greater than a maximum height by which the focus ring is jacked up. The focus ring according to the present application has a separable structure. During operation, each ring body can be jacked up, so that a large space formed beneath a conventional focus ring after it is raised as a whole is divided into several small spaces by the ring bodies. The small spaces are communicated only by narrow gaps between structures. The concentration and activity of charged particles in the plasma in the small spaces are limited, thereby preventing arc discharge and avoiding issues of ignition marks or fragmentation of the focus ring.

### BRIEF DESCRIPTION OF THE DRAWINGS

To more clearly illustrate technical solutions in embodiments of the present application or in the related art, drawings used in description of the embodiments of the present application or the related art are briefly introduced below. Apparently, the drawings in the following description relate to only some of the embodiments of the present application, and other drawings may be obtained by those skilled in the art based on the provided drawings without any creative effort.
FIG. 1 is a schematic structural view of a focus ring in the related art after it is jacked up;
FIG. 2 is a partial schematic structural view of a focus ring according to an embodiment of the present application;
FIG. 3 is a partial schematic structural view of a focus ring according to another embodiment of the present application;
FIG. 4 is a partial schematic structural view of a focus ring according to yet another embodiment of the present application;
FIG. 5 is a partial sectional view of etch equipment provided with a focus ring according to an embodiment of the present application;
FIG. 6 is a partial sectional view of the etch equipment provided with the focus ring according to the embodiments of the present application after the focus ring is eroded and before it is jacked up;
FIG. 7 is a partial sectional view of the etch equipment provided with the focus ring according to the embodiments of the present application after the focus ring is eroded and jacked up;
FIG. 8 is a sectional view of a focus-ring jacking structure according to an embodiment of the present application, taken along an axis of the focus ring;
FIG. 9 is a sectional view of a focus-ring jacking structure according to an embodiment of the present application, taken perpendicular to a radial direction of the focus ring;
FIG. 10 is a top view of a focus-ring jacking structure according to an embodiment of the present application;
FIG. 11 is a partial sectional view of a focus-ring jacking structure according to an embodiment of the present application, taken at a multi-ratio transmission mechanism;
FIG. 12 is a schematic structural view of a focus-ring jacking structure according to an embodiment of the present application when a multi-ratio plate of the multi-ratio transmission mechanism is in an initial state;
FIG. 13 is a schematic structural view of a focus-ring jacking structure according to an embodiment of the present application during movement of the multi-ratio plate of the multi-ratio transmission mechanism;
FIG. 14 is a sectional view of a focus-ring jacking structure according to another embodiment of the present application, taken along an axis of the focus ring;
FIG. 15 is a sectional view of a focus-ring jacking structure according to another embodiment of the present application, taken perpendicular to a radial direction of the focus ring; and
FIGS. 16 to 20 are partial enlarged schematic views of a part A in FIG. 15 at various stages of a jacking process of the focus-ring jacking structure according to another embodiment of the present application.

Reference numerals in the figures are listed as follows:

| | | | |
|---|---|---|---|
| 10. | focus ring; | 1, 2, 3, 4, 5. | ring body; |
| 20. | focus-ring jacking structure configured to perform evenly spaced jacking; | | |
| 21, 211, 212, 213, 214. | jacking pins; | 22. | positioning sleeve shaft; |
| 23. | transmission rod; | 231. | fixed flange; |
| 232. | bellows; | 233. | rod body; |
| 24. | positioning sleeve; | 241. | guide hole; |
| 25. | follower shaft; | 26. | multi-ratio plate; |
| 261, 262, 263, 264. | multi-ratio notches; | 27. | guide sliding mechanism; |
| 271. | guide rail; | 272. | slider; |
| 28. | fixed seat; | 29. | push-rod stepper motor; |
| 20'. | focus-ring jacking structure configured | to | perform sequential jacking; |
| 21', 211', 212', 213', 214'. | jacking pins; | 22'. | positioning sleeve shaft; |
| 23'. | jacking seat; | 24'. | transmission rod; |
| 241'. | fixed flange; | 242'. | bellows; |
| 243'. | rod body; | 25'. | stop pin; |
| 26'. | motor mounting seat; | 27'. | push-rod stepper motor; |
| 28'. | motor cover; | 30. | wafer; |
| 40. | electrostatic chuck; | 50. | intermediate ring; |
| 60. | peripheral ring; | 70. | insulating ring; |
| 80. | base. | | |

### DETAILED DESCRIPTION OF THE EMBODIMENTS

A core aspect of the present application is to provide a focus ring, which has such a structural design that can prevent occurrence of arc discharge in an excessive space formed beneath the focus ring after it is jacked up, thereby avoiding issues of formation of ignition marks or fragmentation of the focus ring.

Another core aspect of the present application is to provide a focus-ring jacking structure for the focus ring as described above, as well as a plasma etching device and etch equipment having the focus ring and the focus-ring jacking structure as described above.

The technical solutions in embodiments of the present application will be described clearly and completely below with reference to the drawings relating to the embodiments of the present application. Apparently, the described embodiments are only a part, rather than all, of the embodiments of the present application. All other embodiments obtained by those skilled in the art based on the embodiments of the present application without any creative effort shall fall within the scope of protection of the present application.

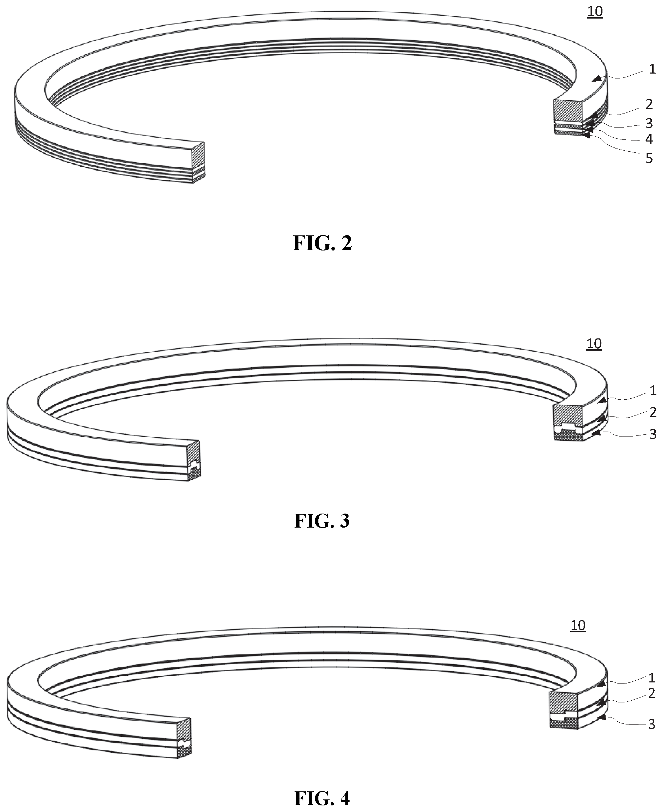

Reference is made to FIG. 2, which is a partial schematic structural view of a focus ring according to an embodiment of the present application.

A focus ring 10 is disclosed according to an embodiment of the present application. The focus ring 10 includes multiple ring bodies that are stacked. That is, the ring bodies of the focus ring 10 are stacked one above the other. The ring bodies may have identical or different axial dimensions. The ring bodies are arranged independently of one another, so that when the ring bodies of the focus ring 10 are jacked up, an isolated small space is formed below each ring body. That is, the space formed by jacking up the focus ring 10 is partitioned by the ring bodies of the focus ring 10 into multiple small spaces. The small spaces are communicated only by narrow gaps between structures. Density and activity of charged particles in the plasma in each small space are restricted, thereby preventing arc discharge. It should be noted that only an uppermost ring body of the ring bodies of the focus ring 10 is allowed to be etched. Thus, an axial dimension of the uppermost ring body is greater than a maximum height by which the focus ring 10 is jacked up.

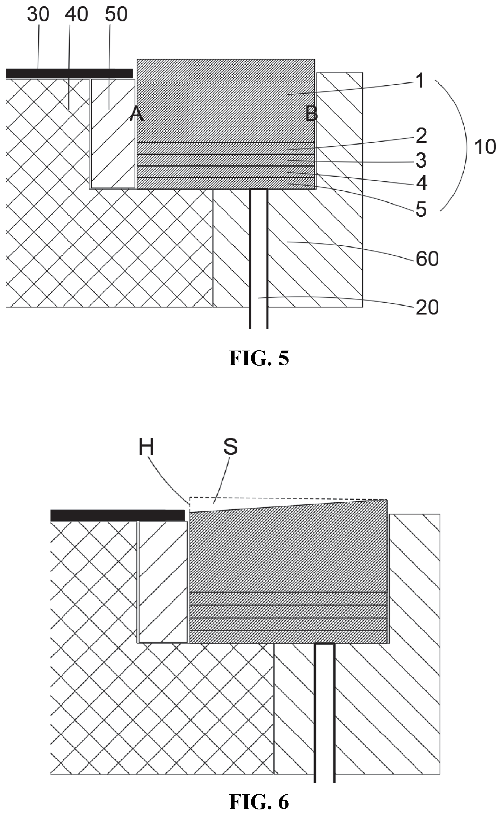

The focus ring 10 according to the embodiment of the present application adopts a separable structure. During operation, each ring body of the focus ring 10 can be jacked up. As shown in FIGS. 5 to 7, the focus ring 10 includes five ring bodies, which are, from top to bottom, a ring body 1, a ring body 2, a ring body 3, a ring body 4 and a ring body 5. The case where the focus ring 10 includes five ring bodies is merely a specific embodiment provided for illustrative purposes in the present application. In practice, the number of the ring bodies is not limited to five. The number of the ring bodies of the focus ring 10 may alternatively be two, three, four, six, seven, or other positive integers. The focus ring 10 is arranged in a space defined by a wafer 30, an electrostatic chuck 40, an intermediate ring 50, and a peripheral ring 60. An upper surface of the uppermost ring body 1 of the focus ring 10 is positioned above an upper surface of the wafer 30, so as to change distribution and morphology of a plasma sheath in a peripheral region of the wafer 30.

The lowest ring body 5 of the focus ring 10 may be supported by both the electrostatic chuck 40 and the peripheral ring 60, or by a focus-ring jacking structure 20. As shown in FIG. 5, a narrow gap is present between a side A (an inner side surface) of the focus ring 10 and the intermediate ring 50, and a narrow gap is present between a side B (an outer side surface) of the focus ring 10 and the peripheral ring 60. These narrow gaps ensure that there is no friction on both the side A and the side B of the focus ring 10 during the jacking process, thereby reducing the risk of particle generation. In some structures, the intermediate ring 50 may not be provided. Instead, the intermediate ring 50 is replaced by a ceramic outer ring of the electrostatic chuck 40.

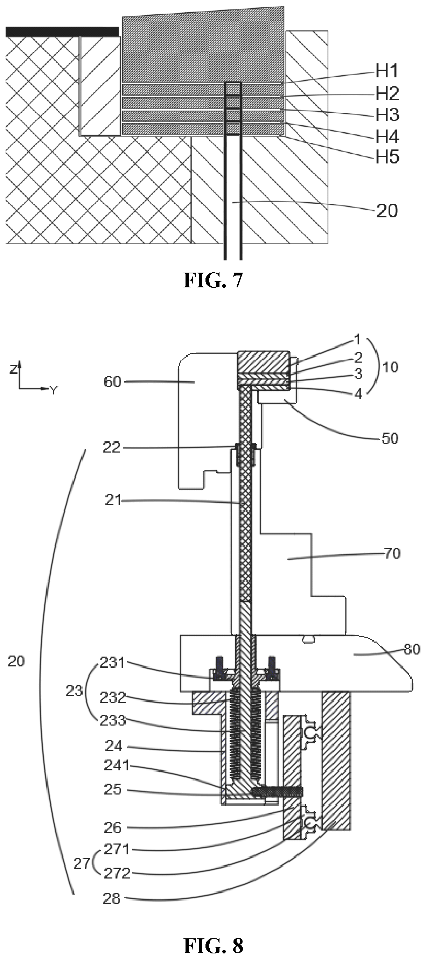

After a predetermined radio frequency heating (RFH) time, the uppermost ring body 1 of the focus ring 10 is etched. As shown in FIG. 6, the etched amount S is larger on the inner side and smaller on the outer side, with a maximum etch height H occurring on the inner side. When the etched amount S is detected to reach a predetermined threshold, the focus-ring jacking structure 20 drives the focus ring 10 upward by the maximum etch height H to maintain process stability, where H = H1 + H2 + H3 + H4 + H5, as shown in FIG. 7.

In summary, compared with the related art, the focus ring 10 provided in the embodiment of the present application adopts a separable structure, and the large space formed beneath a conventional focus ring 10 after it is jacked up as a whole can be divided into several small spaces by the ring bodies. The small spaces are communicated only by narrow gaps between structures. The concentration and activity of charged particles in the plasma in the small spaces are limited, thereby preventing arc discharge and avoiding issues of ignition marks or fragmentation of the focus ring 10.

As shown in FIG. 2, an axial dimension (thickness) of the uppermost ring body 1 is greater than an axial dimension of each of the remaining ring bodies 2, 3, 4, and 5 to withstand the etching during the fabrication process. Each of the remaining ring bodies has an axial dimension less than the axial dimension of the uppermost ring body, and is only used to divide the space under the uppermost ring body after it is jacked up. The axial dimensions of the remaining ring bodies excluding the uppermost ring body may be identical or different from each other. In an embodiment of the present application, the axial dimensions of the remaining ring bodies excluding the uppermost ring body are identical, so as to facilitate subsequent control of the focus-ring jacking structure 20.

Preferably, mating surfaces between every two adjacent ring bodies are annular planar surfaces, conical surfaces, or surfaces respectively provided with a protrusion and a recess. The annular planar surfaces may or may not be perpendicular to an axis of the ring bodies. Tapering directions and cone angles of the conical surfaces of different pairs of adjacent ring bodies may be the same or different. As shown in FIG. 2, in a specific embodiment of the present application, the mating surfaces between every two adjacent ring bodies are annular planar surfaces and are perpendicular to the axis of the ring bodies. Such focus ring 10 with planar mating surfaces has a simple structural design, is easy to manufacture, and can be used in most operational conditions.

In other embodiments, mating surfaces between every two adjacent ring bodies are curved surfaces; or, mating surfaces between every two adjacent ring bodies are zigzag surfaces; or, pairs of mating surfaces between adjacent ring bodies are in a combination of at least two of following configurations: a pair of planar surfaces, a pair of curved surfaces, and a pair of zigzag surfaces.

Specifically, as shown in FIG. 3, in another embodiment of the present application, one of mating surfaces between every two adjacent ring bodies includes a first annular boss and a first annular groove that are alternately arranged along a radial direction of the ring bodies, the other of the mating surfaces between the two adjacent ring bodies includes a second annular boss and a second annular groove that are alternately arranged along the radial direction of the ring bodies. The first annular boss is received in the second annular groove, and the second annular boss is received in the first annular groove.

As shown in FIG. 4, in yet another embodiment of the present application, each of mating surfaces between every two adjacent ring bodies include multiple annular abutment surfaces arranged along the radial direction of the ring bodies with one nested in another. The annular abutment surfaces are sequentially arranged along the axial direction of the ring bodies and are spaced apart in the axial direction of the ring bodies to form a stepped shape.

It should be noted that the aforementioned structures, namely the planar surfaces, conical surfaces, or surfaces with protrusion and recess, may be provided together with the mating surfaces shown in FIG. 3 or FIG. 4, as long as every two adjacent ring bodies can be stacked on one another.

The two mating surface configurations shown in FIGS. 3 and 4 can further divide the small space between the two ring bodies into multiple smaller spaces, which is more effective in preventing the occurrence of arc discharge. However, due to limitations of designed thickness and material brittleness of the component, these two configurations are generally used only in conditions with a small number of ring bodies.

Preferably, in an embodiment of the present application, the materials of the multiple ring bodies of the focus ring 10 may be the same or different. The uppermost ring body is made of one of SiO₂, Si, SiC, and Y₂O₃, and each of the remaining ring bodies is made of SiO₂ or Al₂O₃.

A focus-ring jacking structure for jacking up the focus ring 10 described in the above embodiments is provided according to an embodiment of the present application. The focus-ring jacking structure includes a driving part and multiple actuation parts. The driving part is drivingly connected to the actuation parts. The actuation parts are provided in one-to-one correspondence with the ring bodies of the focus ring 10. Each actuation part may have multiple actuation ends. The multiple actuation ends are distributed along a circumferential direction of the respective ring body of the focus ring 10 and are spaced apart from each other. Preferably, the actuation ends are evenly distributed in the circumferential direction of the respective ring body of the focus ring 10. Alternatively, multiple focus-ring jacking structures are provided for one focus ring 10, and are distributed in a circumferential direction of the focus ring 10 and are spaced apart from each other, and actuation parts of the multiple focus-ring jacking structures operate synchronously. The driving part of the focus-ring jacking structure is configured to drive the respective actuation parts to jack up the respective ring bodies of the focus ring 10 by respective predetermined heights according to a predetermined instruction.

Specifically, in an embodiment shown in FIGS. 8 to 11, a focus-ring jacking structure 20 configured to perform evenly spaced jacking is provided. The focus-ring jacking structure 20 for evenly spaced jacking includes a jacking pin member, a multi-ratio transmission mechanism, a positioning member, and a driving module.

The jacking pin member includes multiple jacking pins 21 that are drivingly connected to the respective ring bodies of the focus ring 10. A number of the jacking pins 21 is a positive integer multiple of a number of the ring bodies of the focus ring 10. For example, the number of the jacking pins 21 may be the same as the number of the ring bodies of the focus ring 10, or may be 2 times, 3 times... the number of the ring bodies of the focus ring 10. The jacking pins serve as the actuation parts of the focus-ring jacking structure 20 for evenly spaced jacking. Upper end surfaces of the jacking pins 21 are configured to be coupled with bottom surfaces of the respective ring bodies of the focus ring 10 via physical contact. To ensure that jacking forces applied on the respective ring bodies are consistent with each other, in an embodiment of the present application, the jacking pins 21 are arranged circumferentially around an axis of the focus ring 10 and are spaced apart from each other.

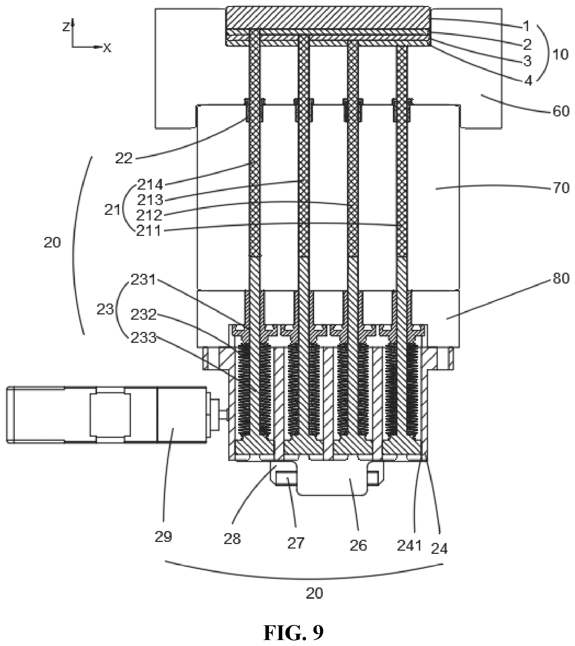

As shown in FIGS. 8 and 9, the focus-ring jacking structure 20 for evenly spaced jacking is mounted on a base 80 of etch equipment. The focus-ring jacking structure 20 extends from bottom to top through an insulating ring 70, the intermediate ring 50, and the peripheral ring 60 to come into contact with the ring bodies of the focus ring 10 only through the respective thin, small jacking pins 21, thereby jacking up the respective ring bodies of the focus ring 10 to achieve the evenly spaced jacking. The base 80 serves as a partition between a vacuum environment and an atmospheric environment. A part of the focus-ring jacking structure 20 for evenly spaced jacking located below the base 80 is in the atmospheric environment, while another part of the focus-ring jacking structure 20 for evenly spaced jacking located above the base 80 is in the vacuum environment.

Preferably, to ensure the movement stability of the jacking pins 21, as shown in FIG. 9, in this embodiment, positioning sleeve shafts 22 are disposed on the insulating ring 70 and/or the peripheral ring 60. The jacking pins 21 extend through the respective positioning sleeve shafts 22. The positioning sleeve shafts 22 are configured to constrain and guide the respective jacking pins 21, so that each jacking pin 21 is slidable in both directions along a predetermined direction.

The multi-ratio transmission mechanism includes a multi-ratio plate 26 and transmission rods 23. The multi-ratio plate 26 is provided with transmission structures that are drivingly coupled with the respective transmission rods 23 in one-to-one correspondence. The transmission rods 23 are drivingly connected to the respective jacking pins 21. Ends of the transmission rods 23 away from the jacking pins 21 are coupled with the respective transmission structures via physical contact. Transmission ratios of the transmission structures decrease proportionally according to an arrangement order of the respective ring bodies from top to bottom within the focus ring 10. That is, when the multi-ratio plate 26 moves perpendicular to the axial direction of the focus ring 10, movement distances of the jacking pins 21 decrease proportionally with the arrangement order of the respective ring bodies from top to bottom within the focus ring 10. The transmission structure connected to the jacking pin corresponding to the uppermost ring body has a highest transmission ratio, and the transmission ratios of the transmission structures connected to the jacking pins corresponding to the respective ring bodies below the uppermost ring body decrease from top to bottom. That is, as the multi-ratio plate 26 moves, the jacking pins 21 also move accordingly, but the movement distances of the jacking pins 21 are different.

The aforementioned moving direction of the multi-ratio plate 26 is described based on the rectangular multi-ratio plate 26 shown in FIGS. 8 to 11. The actual moving direction of the multi-ratio plate 26 is not limited to the bidirectional movement perpendicular to the axial direction of the focus ring 10. For example, the multi-ratio plate 26 may be an arc-shaped plate or an annular plate, and the jacking pins 21 may be driven by rotating the multi-ratio plate 26 around the axial direction of the focus ring 10. In this case, the multi-ratio plate 26 may be provided with multiple groups of transmission structures to simultaneously drive multiple groups of jacking pins 21 through the transmission rods 23. Each group of transmission structures can drive jacking pins 21 provided in the same number as the ring bodies of the focus ring 10 and in one-to-one correspondence with the ring bodies of the focus ring 10. That is, the multi-ratio plate 26 has such a structural design that enables it to simultaneously drive multiple jacking pin members.

In the above embodiment, the transmission rod 23 includes a rod body 233, a fixed flange 231 and a bellows 232. The fixed flange 231 is configured to be fixedly connected to the base 80 of the etch equipment in a sealing manner. An annular sealing groove is provided in a flange surface of the fixed flange 231 that is coupled with the base 80. A sealing ring is disposed in the annular sealing groove to achieve static sealing between the fixed flange 231 and the base 80. The rod body 233 extends through the fixed flange 231 and is drivingly connected to the jacking pin member. Two ends of the bellows 232 are respectively connected to the fixed flange 231 and a bottom seat of the rod body 233 in a sealing manner. The bellows 232 is configured for dynamic sealing between the fixed flange 231 and the rod body 233. During operation, the bellows 232 is pushed and compressed, which ensures stable vertical movement of the rod body and also meets the requirement that the part of the focus-ring jacking structure 20 above the base 80 is in a vacuum environment.

The positioning member is configured to guide and position each of the jacking pins 21 and/or the transmission rods 23 such that each of the jacking pins is movable in both directions along the axial direction of the focus ring 10. Because the jacking pins 21 need to move different distances, the moving direction of the multi-ratio plate 26 is different from the moving directions of the jacking pin 21. In order to ensure that the jacking pins 21 or the transmission rods 23 move along a predetermined direction, the positioning member is provided to guide the jacking pins 21 and/or the transmission rods 23.

The driving module is configured to drive the multi-ratio plate 26 to move in both directions along a predetermined direction. A movement path of the multi-ratio plate 26 may be straight or curved. The driving module is a piston cylinder; or the driving module is a linear motor; or the driving module includes a rotary motor and a transmission mechanism configured to convert rotation of the rotary motor into bidirectional movement. The piston cylinder may be a pneumatic cylinder or a hydraulic cylinder. The transmission mechanism may be a lead screw-slider mechanism, a gear-rack mechanism, a cam-linkage mechanism, etc. In a specific embodiment of the present application, the driving module is configured as a push-rod stepper motor 29, which integrates a stepper motor and a high-precision lead screw structure. A rotational motion of the stepper motor is directly converted into a high-precision linear motion, resulting in a compact structure. An output shaft of the push-rod stepper motor 29 is fixed to the multi-ratio plate 26, thereby pushing the multi-ratio plate 26 to achieve controllable, high-precision horizontal movement.

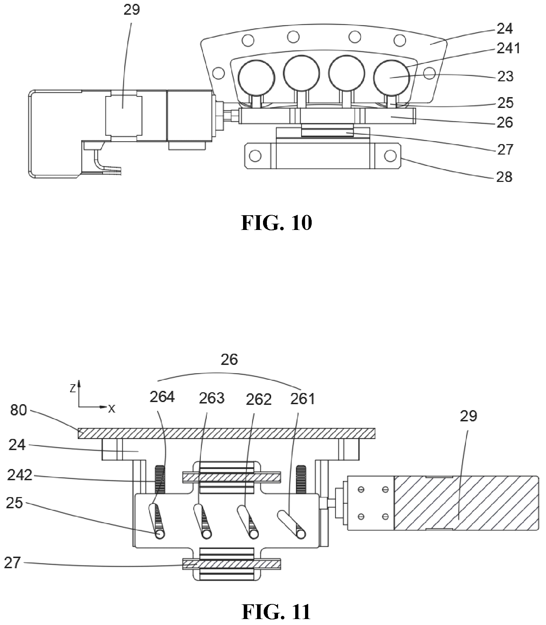

Preferably, in an embodiment of the present application, as shown in FIG. 11, the transmission structures are configured as multi-ratio notches 261-264. A follower shaft 25 is disposed at a bottom part of each transmission rod 23. An axis of the follower shaft 25 intersects with an axis of the transmission rod 23. The follower shaft 25 is slidably coupled with a corresponding one of the multi-ratio notches 261-264. The follower shaft 25 is connected to the bottom seat of the rod body 233 of the transmission rod 23. A connecting line is defined between two ends of each notch of the multi-ratio notches. Angles between the connecting lines and a horizontal plane decrease proportionally according to the arrangement order of the respective ring bodies from top to bottom within the focus ring 10. As can be seen from FIG. 11, in a case where the focus ring 10 has four ring bodies, the multi-ratio plate is provided with four multi-ratio notches 261-264 arranged in sequence from right to left. A leftmost notch 264 is drivingly connected to the uppermost ring body of the focus ring 10, and an angle between the connecting line between the two ends of the leftmost notch 264 and the horizontal plane is the largest among the four multi-ratio notches 261-264. Angles between the connecting lines between the two ends of the remaining multi-ratio notches 263, 262, and 261 and the horizontal plane decrease in the listed sequence.

The "evenly spaced" jacking of the focus-ring jacking structure 20 in the embodiment of the present application is realized through mid curve functions of the multi-ratio notches 261-264 of the multi-ratio plate 26, as shown in FIG. 11. A motor drives the multi-ratio plate 26 to move in an X direction as shown, while the follower shafts 25 received in respective ones of the multi-ratio notches 261-264 are constrained to move only in a Z direction as shown. The relationships between a displacement of the multi-ratio plate 26 and displacements of the respective follower shafts 25 are controlled by the mid curve functions of respective ones of the multi-ratio notches 261-264. By configuring the mid curve functions to be proportional, the "evenly spaced" jacking can be performed by the focus-ring jacking structure 20, i.e., clearances below the respective ring bodies remain equal to each other throughout jacking and lowering processes.

Through the design of the multi-ratio notches 261-264 described above, when the driving module drives the multi-ratio plate 26 to move left or right, since the multi-ratio notches 261-264 are inclined and have proportional mid curve functions, the left and right movements of the multi-ratio plate 26 can be converted into the downward and upward movements of the jacking pins 21 and the transmission rods 23 through the sliding coupling between the multi-ratio notches 261-264 and the respective follower shafts 25. That is, when the driving module drives the multi-ratio plate 26 to the right, the jacking pins 21 and the transmission rods 23 move upward; when the driving module drives the multi-ratio plate 26 to the left, the jacking pins 21 and the transmission rods 23 move downward. Furthermore, because the angles between respective ones of the multi-ratio notches 261-264 and the horizontal plane decrease proportionally from left to right, the movement distances of the ring bodies 1-4 of the focus ring 10 also decrease from top to bottom during the movement of the multi-ratio plate 26, ensuring that a clearance is created below each ring body and that all the clearances are always equal.

The aforementioned terms "upward", "downward", "left", "right", "X", and "Z" are only for the convenience of explaining the movement directions of the multi-ratio plate 26, the jacking pins 21, and the transmission rods 23, and only apply to the orientation shown in FIG. 11. In actual applications, the movement directions of the multi-ratio plate 26, the jacking pins 21, and the transmission rods 23 are determined according to actual arrangements.

In the above embodiment, when the transmission structures are the multi-ratio notches 261-264, the positioning member includes a positioning sleeve 24. Guide holes 241 are provided in the positioning sleeve 24, and guide grooves in communication with the respective guide holes 241 are provided in a side wall of the positioning sleeve 24 corresponding to the respective guide holes 241. The transmission rods 23 are slidably coupled with the respective guide holes 241. In an embodiment of the present application, the bottom seats of the rod bodies 233 of the transmission rods 23 are slidably coupled with the respective guide holes 241, and the transmission rods 23 are movable in both upward and downward directions under the guiding and position-limiting effect of the guide holes 241. Length directions of the guide grooves are parallel to axial directions of the guide holes 241. The follower shafts 25 extend out of the respective guide grooves to be coupled with respective ones of the multi-ratio notches 261-264 via physical contact.

It should be noted that the configuration of the transmission structures is not limited to the above embodiment. In another embodiment, the transmission structures are configured as multi-ratio inclined surfaces. Angles between respective ones of the multi-ratio inclined surfaces and the horizontal plane decrease proportionally according to the arrangement order of the respective ring bodies from top to bottom within the focus ring 10.

Preferably, as shown in FIGS. 10 and 11, the focus-ring jacking structure for evenly spaced jacking further includes a fixed seat 28. The multi-ratio plate 26 is disposed on the fixed seat 28 and is movable in both directions perpendicular to the axial direction of the focus ring 10. The fixed seat 28 provides an installation position and support for the multi-ratio plate 26 to ensure the stability of the movement of the multi-ratio plate 26.

Specifically, as shown in FIG. 11, in an embodiment of the present application, the multi-ratio plate 26 is coupled with the fixed seat 28 through a guide sliding mechanism 27. The guide sliding mechanism 27 includes a slider 272 disposed on one of the fixed seat 28 and the multi-ratio plate 26 and a guide rail 271 disposed on the other of the fixed seat 28 and the multi-ratio plate 26. The slider 272 is slidably coupled with the guide rail 271 to allow the multi-ratio plate 26 to be slidably connected to the fixed seat 28. The guide rail 271 and the slider 272 cooperate with each other to constrain the slider, so as to ensure that the multi-ratio plate 26 is movable relative to the fixed seat 28 along a predetermined direction (a left-right direction in FIG. 11).

Specifically, in the embodiment shown in FIGS. 8 and 9, the focus ring 10 is composed of four parts, namely a ring body 1, a ring body 2, a ring body 3, and a ring body 4. Correspondingly, there are four jacking pins, namely a jacking pin 211, a jacking pin 212, a jacking pin 213, and a jacking pin 214. The four ring bodies are in contact with the four jacking pins in one-to-one correspondence. Bottom parts of the four jacking pins are connected to the respective transmission rods 23, which are respectively controlled by a notch 261, a notch 262, a notch 263, and a notch 264 of the multi-ratio notches via the follower shafts 25, as shown in FIG. 11. The mid curve functions of the four multi-ratio notches adopt the simplest linear functions: Z = n × X.

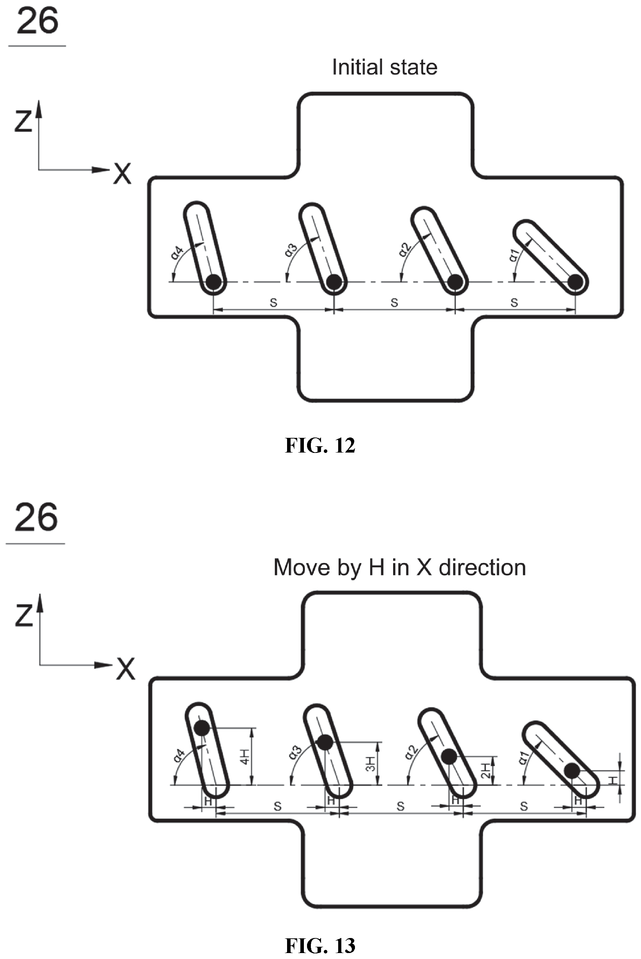

As shown in FIGS. 11 and 12, in an initial state, the follower shafts 25 are uniformly distributed on a same horizontal line. A distance between every two adjacent follower shafts 25 is S. The mid curve function of the notch 261 (a rightmost notch) is defined as Z = X, where α1 = 45°. The notch 261 corresponds to the lowermost ring body 4 of the focus ring 10. The mid curve function of the notch 262 is defined as Z = 2 × X, where α2 = 26.565°. The notch 262 corresponds to the ring body 3 of the focus ring 10. The mid curve function of the notch 263 is defined as Z = 3 × X, where α3 = 18.435°. The notch 263 corresponds to the ring body 2 of the focus ring 10. The mid curve function of the notch 264 is defined as Z = 4 × X, where α4 = 14.036°. The notch 264 corresponds to the uppermost ring body 1 of the focus ring 10.

As shown in FIG. 13, in a moving state, the multi-ratio plate 26 moves a distance H in the X direction, and 0 < H ≤ Htotal, where Htotal is a maximum movement distance of the multi-ratio plate 26 in the X direction. At this point, the follower shafts 25 at the multi-ratio notches 261-264, from right to left, move by heights of H, 2H, 3H, and 4H, respectively. The corresponding ring bodies, from bottom to top, of the focus ring 10 are raised by H, 2H, 3H, and 4H, respectively. A height of each of the small spaces separating every two ring bodies and the small space located under the lowermost ring body is H, thereby effectively achieving the evenly spaced jacking.

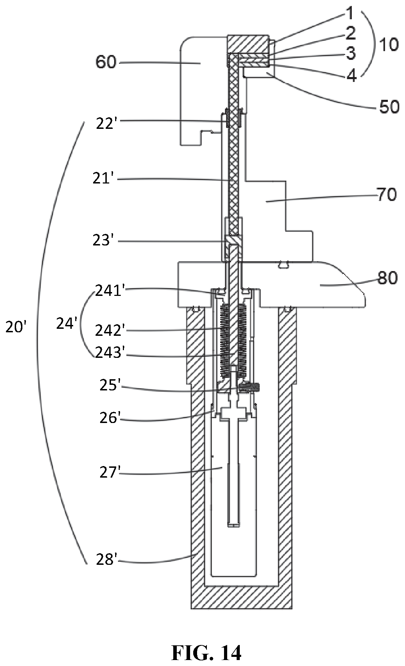

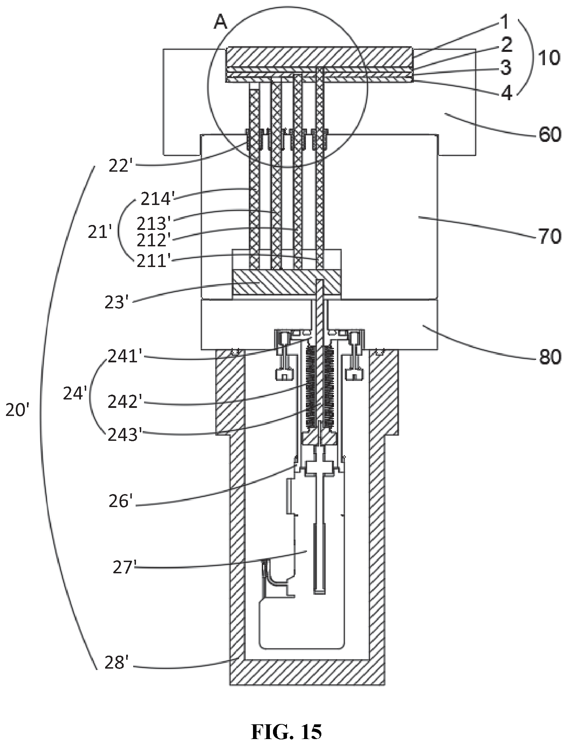

In another embodiment, as shown in FIGS. 14 and 15, a focus-ring jacking structure 20' configured to perform sequential jacking is provided. Differing from the focus-ring jacking structure 20 for evenly spaced jacking described above, the driving method of the focus-ring jacking structure 20' for sequential jacking does not cause all ring bodies to move simultaneously, but rather causes each ring body to begin moving in a predetermined order.

As shown in FIGS. 14 to 16, the focus-ring jacking structure 20' for sequential jacking includes a jacking pin member and a driving module. The jacking pin member includes a jacking seat 23' and multiple jacking pins 21' disposed on the jacking seat 23' and corresponding to the respective ring bodies of the focus ring 10. The number of the jacking pins 21' may be the same as the number of the ring bodies of the focus ring 10, or may be a positive integer multiple of the number of the ring bodies of the focus ring 10. Clearances between the jacking pins 21' and the respective ring bodies increase in arithmetic progression according to the arrangement order of the corresponding ring bodies from top to bottom in the focus ring 10. The jacking pins 21' serve as the actuation parts of the focus-ring jacking structure 20' for sequential jacking. That is, the jacking pin 211' corresponding to the uppermost ring body 1 may or may not be in contact with the uppermost ring body 1, the jacking pins corresponding to the remaining ring bodies are not in contact with the respective ring bodies, and clearances between the jacking pins and the respective ring bodies increase in arithmetic progression according to an order of the respective ring bodies from top to bottom.

As shown in FIGS. 14 and 15, in this embodiment, the focus-ring jacking structure 20' for sequential jacking is mounted on the base 80 of the etch equipment, extending from bottom to top through the insulating ring 70, the intermediate ring 50, and the peripheral ring 60 to come into contact with the ring bodies of the focus ring 10 through the respective jacking pins 21', thereby driving the respective ring bodies of the focus ring 10 to be sequentially jacked up. The base 80 serves as a partition between a vacuum environment and an atmospheric environment. A part of the focus-ring jacking structure 20' for sequential jacking located below the base 80 is in the atmospheric environment, while another part of the focus-ring jacking structure 20' for sequential jacking located above the base 80 is in the vacuum environment.

Preferably, to ensure the movement stability of the jacking pins 21', as shown in FIGS. 14 and 15, in this embodiment, positioning sleeve shafts 22' are disposed on the insulating ring 70 and/or the peripheral ring 60. The jacking pins 21' extend through the respective positioning sleeve shafts 22'. The positioning sleeve shafts 22' are configured to constrain and guide the respective jacking pins 21', so that the jacking pins 21' are slidable in both directions along a predetermined direction.

The driving module is drivingly connected to the jacking seat 23' through a transmission rod 24' to drive the jacking seat 23' to move in both directions along the axial direction of the focus ring 10. The driving module may be a piston cylinder or a linear motor, or the driving module may include a rotary motor and a transmission mechanism configured to convert rotation of the rotary motor into bidirectional movement. The piston cylinder may be a pneumatic cylinder or a hydraulic cylinder. The transmission mechanism may be a lead screw-slider mechanism, a gear-rack mechanism, a cam-linkage mechanism, etc.

In a specific embodiment of the present application, the driving module is configured as a push-rod stepper motor 27', which integrates a stepper motor and a high-precision lead screw structure. A rotational motion of the stepper motor can be directly converted into a high-precision linear motion, resulting in a compact structure. An output shaft of the push-rod stepper motor 27' is fixed to the jacking seat 23', thereby pushing the jacking seat 23' to achieve controllable, high-precision vertical movement.

The push-rod stepper motor 27' is fixedly mounted on the base 80 by a motor mounting seat 26' and is enclosed by a motor cover 28' mounted on the base 80. The motor cover 28' is coupled with the base 80 in a sealing manner to form a sealed and stable operating space, which is isolated from air to form a vacuum environment. In this way, the push-rod stepper motor 27' is disposed in the vacuum environment and is prevented from being affected by dust and impurities, ensuring the normal operation of the push-rod stepper motor 27', extending the service life of the push-rod stepper motor 27', and reducing the number of maintenance operations, thereby improving the reliability of the etch equipment.

Under some operating conditions, a vacuum environment exists in a part of a space at the bottom of the base 80. To facilitate the design of a fixation position of the motor, a motor cover 28' is provided to achieve isolation from the atmospheric environment, creating a local vacuum environment to accommodate the push-rod stepper motor 27'. Of course, the motor cover 28' is not necessary and may be omitted under certain operating conditions.

The driving module is connected to the jacking seat 23' through a transmission rod 24'. The transmission rod 24' includes a rod body 243', a fixed flange 241', and a bellows 242'. The fixed flange 241' is configured to be fixedly connected to the base 80 of the etch equipment in a sealing manner. An annular sealing groove is provided in a flange surface of the fixed flange 241' that is coupled with the base 80. A sealing ring is disposed in the annular sealing groove to achieve static sealing between the fixed flange 241' and the base 80. The rod body 243' extends through the fixed flange 241' and is drivingly connected to the jacking seat 23'. Both ends of the bellows 242' are respectively connected to the fixed flange 241' and a bottom seat of the rod body 243' in a sealing manner. The bellows 242' is configured for dynamic sealing between the fixed flange 241' and the rod body 243'. During operation, the bellows 242' is pushed and compressed, which ensures stable vertical movement of the rod body 243', and meets a requirement that the part of the focus-ring jacking structure above the base 80 is located in a vacuum environment. The bottom seat of the rod body 243' is slidably coupled with an inner wall of the motor mounting seat 26' to constrain and guide the transmission rod 24'. Further, a position-limiting slide groove is provided on a side wall of the motor mounting seat 26', and a stop pin 25' is provided on the bottom seat of the rod body 243'. The stop pin 25' is coupled with the position-limiting slide groove to prevent the transmission rod 24' from rotating.

The "sequential" jacking of the focus-ring jacking structure 20' mentioned above refers to a transition in the configuration for dividing the space formed by the jacking process, where the divided spaces gradually transition from being larger at the top and smaller at the bottom to becoming consistent with each other and reaching a stable state. During the jacking process, the ring bodies of the focus ring 10 are jacked sequentially from top to bottom until all the ring bodies are jacked up to their respective predetermined positions. At this time, a height by which the uppermost ring body is jacked up is referred to as a total jacking height Htotal. The condition for a next ring body of the focus ring 10 to be jacked up is that a height of the small divided space above the next ring body of the focus ring 10 reaches a predetermined maximum height Hmax. For a structure where the focus rings 10 has N ring bodies, Hmax = Htotal / N. Moreover, when any ring body of the focus ring 10 is jacked up, it moves together with all the ring bodies of the focus rings 10 above it, and the height of the small space that has been formed will no longer change and will keep equal to Hmax.

The process of sequential jacking is described below with reference to specific embodiments.

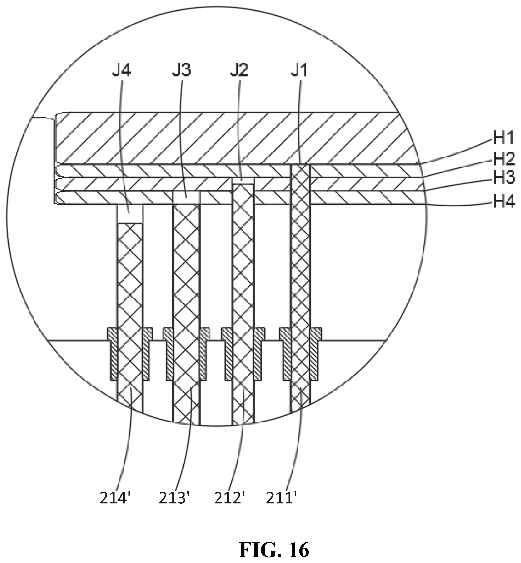

As shown in FIG. 16, in the embodiment illustrated in this figure, the focus ring 10 is in an unjacked state. The focus ring 10 is composed of four parts, namely a ring body 1, a ring body 2, a ring body 3, and a ring body 4, that are stacked in the listed sequence from top to bottom. Correspondingly, four jacking pins 211', 212', 213', and 214' are provided. A top of each jacking pin has a different height. The four jacking pins are, from highest to lowest, a jacking pin 211' corresponding to the ring body 1, a jacking pin 212' corresponding to the ring body 2, a jacking pin 213' corresponding to the ring body 3, and a jacking pin 214' corresponding to the ring body 4.

As shown in FIG. 16, in a free state, predetermined clearances between the four ring bodies and the respective jacking pins are J1, J2, J3, and J4, respectively, where J1 < J2 < J3 < J4. A maximum height of each small space formed by the division is defined as Hmax. Accordingly, J1 ≥ 0, J2 = J1 + Hmax, J3 = J2 + Hmax, and J4 = J3 + Hmax. J1, J2, J3, and J4 increase in an arithmetic progression, thereby achieving the "sequentially" jacking.

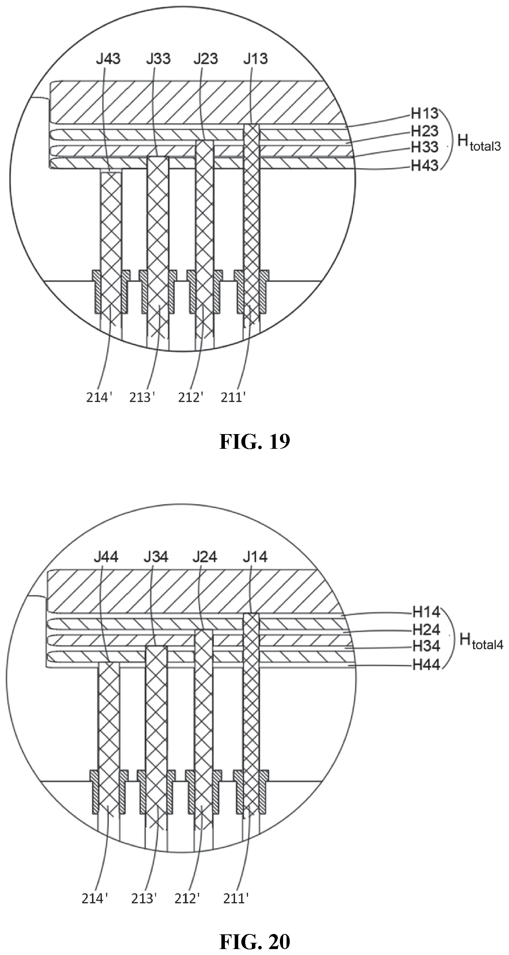

For ease of understanding, the heights of the small spaces formed by the division are defined as H1, H2, H3, and H4 from top to bottom. As shown in FIG. 16, in an initial state where the focus ring 10 is not yet jacked up, H1 = H2 = H3 = H4 = 0. As shown in FIG. 20, in a final state where all the ring bodies of the focus ring 10 are jacked up to their respective predetermined positions, H14 = H24 = H34 = H44 = Hmax. After reaching the final state, the focus-ring jacking structure for sequential jacking is no longer allowed to move.

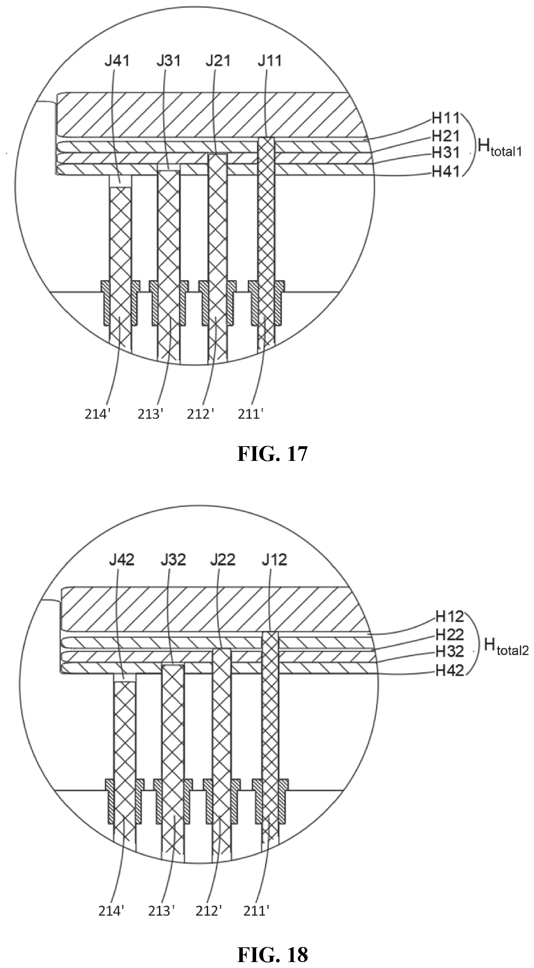

As shown in FIG. 17, at the moment illustrated, a total jacking height Htotal1 satisfies Htotal1 ≤ Hmax. At this point, only the ring body 1 is jacked up by a jacking height of H11 = Htotal1, while H21 = H31 = H41 = 0. The clearance J11 between the jacking pin 211' and the ring body 1 satisfies J11 = 0. At the same time, the jacking pins 212', 213', and 214' also move upward synchronously. The clearance J21 between the jacking pin 212' and the ring body 2 is J21 = (Hmax - Htotal1) ≥ 0. The clearance between the jacking pin 213' and the ring body 3 is J31 = J21 + Hmax, and the clearance between the jacking pin 214' and the ring body 4 is J41 = J31 + Hmax.

As shown in FIG. 18, at the moment illustrated, the total jacking height Htotal2 satisfies Hmax < Htotal2 ≤ 2 × Hmax. At this point, only the ring body 1 and the ring body 2 are jacked up, that is, the clearance H12 between the ring body 1 and the ring body 2 satisfies H12 = Hmax. In the subsequent jacking process, the clearance H12 between the ring body 1 and the ring body 2 no longer changes. The clearance H22 between the ring body 2 and the ring body 3 satisfies H22 = Htotal2 - Hmax. The clearance H32 between the ring body 3 and the ring body 4 and the clearance H42 under the ring body 4 satisfy H32 = H42 = 0. The clearance J12 between the jacking pin 211' and the ring body 1 and the clearance J22 between the jacking pin 212' and the ring body 2 satisfy J12 = J22 = 0. The clearance J32 between the jacking pin 213' and the ring body 3 satisfies J32 = (2 × Hmax - Htotal2) ≥ 0. The clearance J42 between the jacking pin 214' and the ring body 4 satisfies J42 = J32 + Hmax.

As shown in FIG. 19, at the moment illustrated, the total jacking height Htotal3 satisfies 2 × Hmax < Htotal3 ≤ 3 × Hmax, and only the ring body 1, the ring body 2, and the ring body 3 are jacked up. At this point, the clearance H13 between the ring body 1 and the ring body 2 and the clearance H23 between the ring body 2 and the ring body 3 satisfy H13 = H23 = Hmax. In the subsequent jacking process, the clearance H13 between the ring body 1 and the ring body 2 and the clearance H23 between the ring body 2 and the ring body 3 no longer change. The clearance H33 between the ring body 3 and the ring body 4 satisfies H33 = Htotal3 - 2 × Hmax. The ring body 4 is not yet jacked up, thus the clearance H43 under the ring body 4 satisfies H43 = 0. At this point, the jacking pin 211' is in contact with the ring body 1, the jacking pin 212' is in contact with the ring body 2, and the jacking pin 213' is in contact with the ring body 3. That is, the clearance J13 between the jacking pin 211' and the ring body 1, the clearance J23 between the jacking pin 212' and the ring body 2, and the clearance J33 between the jacking pin 213' and the ring body 3 satisfy J13 = J23 = J33 = 0. The clearance J43 between the jacking pin 214' and the ring body 4 satisfies J43 = (3 × Hmax - Htotal3) ≥ 0.

As shown in FIG. 20, at the moment illustrated, the total jacking height Htotal4 satisfies 3 × Hmax < Htotal4 ≤ 4 × Hmax, and the ring body 1, the ring body 2, the ring body 3, and the ring body 4 are all jacked up. At this point, the clearance H14 between the ring body 1 and the ring body 2, the clearance H24 between the ring body 2 and the ring body 3, and the clearance H34 between the ring body 3 and the ring body 4 satisfy H14 = H24 = H34 = Hmax, and the clearance H44 under the ring body 4 satisfies H44 = Htotal4 - 3 × Hmax. Each jacking pin is in contact with the respective ring body. That is, the clearance J14 between the jacking pin 211' and the ring body 1, the clearance J24 between the jacking pin 212' and the ring body 2, the clearance J34 between the jacking pin 213' and the ring body 3, and the clearance J44 between the jacking pin 214' and the ring body 4 satisfy J14 = J24 = J34 = J44 = 0.

Preferably, in the above embodiments of the present application, to ensure that jacking forces applied on the respective ring bodies are consistent with each other, the jacking pins are arranged circumferentially around the axis of the focus ring 10 and are spaced apart from each other.

Etch equipment is further provided according to the present application. As shown in FIG. 5, the etch equipment includes the focus ring 10 described in the above embodiments and the focus-ring jacking structure described in the above embodiments. The focus-ring jacking structure may be the focus-ring jacking structure 20 configured to perform evenly spaced jacking or the focus-ring jacking structure 20' configured to perform sequential jacking. Since the etch equipment has the focus ring 10 and the focus-ring jacking structure in the above embodiments, technical effects of the etch equipment may refer to those described in the above embodiments.

As shown in FIG. 5, in the etch equipment, the focus ring 10 is arranged in the space defined by the wafer 30, the electrostatic chuck 40, the intermediate ring 50 and the peripheral ring 60. The upper surface of the uppermost ring body of the focus ring 10 is positioned above the upper surface of the wafer 30, so as to change the distribution and morphology of the plasma sheath in the peripheral region of the wafer 30. The lowermost ring body may be supported by both the electrostatic chuck 40 and the peripheral ring 60, or by the focus-ring jacking structure. A gap is present between the side A of the focus ring 10 and the intermediate ring 50, and a gap is present between the side B and the peripheral ring 60, so as to ensure that there is no friction on both sides A/B of the focus ring 10 during the jacking process, thereby reducing the risk of particle generation. In some structures, the intermediate ring 50 may be omitted. Instead, the intermediate ring 50 is replaced by a ceramic outer ring of the electrostatic chuck 40.

A plasma etching device is further provided in an embodiment of the present application, which includes the etch equipment described in the above embodiments. Since the plasma etching device has the etch equipment according to the above embodiments, the technical effects of the plasma etching device may refer to those described in the above embodiments.

It should be noted that the embodiments described herein are presented in a progressive manner, and each embodiment focuses on its differences from other embodiments. The same or similar parts among the embodiments may refer to one another.

Although specific examples are described for explaining the principle and embodiments of the present application, the description of the examples is only for facilitating understanding of the core concept of the present application. It should be noted that, for those skilled in the art, several improvements and modifications may be made to the present application without departing from the principle of the present application, and these improvements and modifications shall fall within the scope of protection of the claims of the present application.

## Claims

1. A focus ring, comprising a plurality of ring bodies that are stacked and arranged independently of one another, wherein an uppermost ring body of the plurality of ring bodies has an axial dimension greater than a maximum height by which the focus ring is jacked up.

2. The focus ring according to claim 1, wherein the axial dimension of the uppermost ring body is greater than an axial dimension of each of the remaining ring bodies.

3. The focus ring according to claim 2, wherein the axial dimensions of the remaining ring bodies except the uppermost ring body are equal to each other.

4. The focus ring according to any one of claims 1 to 3, wherein mating surfaces between every two adjacent ring bodies are annular planar surfaces or surfaces respectively provided with a protrusion and a recess.

5. The focus ring according to claim 4, wherein the mating surfaces between every two adjacent ring bodies are annular planar surfaces perpendicular to an axis of the ring bodies.

6. The focus ring according to any one of claims 1 to 3, wherein
mating surfaces between every two adjacent ring bodies are curved surfaces; or,
mating surfaces between every two adjacent ring bodies are zigzag surfaces; or,
pairs of mating surfaces between adjacent ring bodies are in a combination of at least two of following configurations: a pair of planar surfaces, a pair of curved surfaces, and a pair of zigzag surfaces.

7. The focus ring according to claim 6, wherein one of mating surfaces between every two adjacent ring bodies comprises a first annular boss and a first annular groove that are alternately arranged along a radial direction of the ring bodies, the other of the mating surfaces between the two adjacent ring bodies comprises a second annular boss and a second annular groove that are alternately arranged along the radial direction of the ring bodies, the first annular boss is received in the second annular groove, and the second annular boss is received in the first annular groove.

8. The focus ring according to claim 6, wherein each of mating surfaces between every two adjacent ring bodies comprise a plurality of annular abutment surfaces arranged along a radial direction of the ring bodies with one nested in another, and the annular abutment surfaces are sequentially arranged along an axial direction of the ring bodies and are spaced apart in the axial direction of the ring bodies to form a stepped shape.

9. The focus ring according to any one of claims 1-3, 5, 7, and 8, wherein the uppermost ring body is made of one of SiO₂, Si, SiC, and Y₂O₃, and each of the remaining ring bodies is made of SiO₂ or Al₂O₃.

10. A focus-ring jacking structure for jacking up the focus ring according to any one of claims 1 to 9, comprising:
a driving part; and,
a plurality of actuation parts, wherein
the driving part is drivingly connected to the actuation parts, the actuation parts are arranged in one-to-one correspondence with the ring bodies of the focus ring, and the driving part of the focus-ring jacking structure is configured to drive the actuation parts to jack up the respective ring bodies of the focus ring by respective predetermined heights according to a predetermined instruction.

11. The focus-ring jacking structure according to claim 10, comprising:
a jacking pin member, comprising a plurality of jacking pins that are drivingly connected to the respective ring bodies of the focus ring;
a multi-ratio transmission mechanism, comprising a multi-ratio plate and transmission rods, wherein the multi-ratio plate is provided with transmission structures that are drivingly coupled with the respective transmission rods in one-to-one correspondence, the transmission rods are drivingly connected to the respective jacking pins, ends of the transmission rods away from the jacking pins are coupled with the respective transmission structures via physical contact, and transmission ratios of the transmission structures decrease proportionally according to an arrangement order of the respective ring bodies from top to bottom within the focus ring;
a positioning member configured to guide and position the jacking pins and/or the transmission rods to allow the jacking pins to move in both directions along an axial direction of the focus ring; and
a driving module configured to drive the multi-ratio plate to move in both directions along a predetermined direction.

12. The focus-ring jacking structure according to claim 11, wherein
the transmission structures are configured as multi-ratio notches, a follower shaft is disposed at a bottom part of each transmission rod, and an axis of each follower shaft intersects with an axis of the respective transmission rod; and
the follower shafts are slidably coupled with respective ones of the multi-ratio notches, a connecting line is defined between two ends of each notch of the multi-ratio notches, and angles between the respective connecting lines and a horizontal plane decrease proportionally according to the arrangement order of the respective ring bodies from top to bottom within the focus ring.

13. The focus-ring jacking structure according to claim 12, wherein the positioning member is provided with guide holes and guide grooves in communication with the respective guide holes, the transmission rods are slidably coupled with the respective guide holes, and the follower shafts extend out of the respective guide grooves to be coupled with respective ones of the multi-ratio notches via physical contact.

14. The focus-ring jacking structure according to claim 11, wherein the transmission structures are configured as multi-ratio inclined surfaces, and angles between respective ones of the multi-ratio inclined surfaces and the horizontal plane decrease proportionally according to the arrangement order of the respective ring bodies from top to bottom within the focus ring.

15. The focus-ring jacking structure according to claim 11, further comprising a fixed seat, wherein the multi-ratio plate is disposed on the fixed seat and is movable in both directions along a direction perpendicular to the axial direction of the focus ring.

16. The focus-ring jacking structure according to claim 15, wherein a slider is disposed on one of the fixed seat and the multi-ratio plate, a guide rail is disposed on the other of the fixed seat and the multi-ratio plate, and the slider is slidably coupled with the guide rail to allow the multi-ratio plate to be slidably connected to the fixed seat.

17. The focus-ring jacking structure according to claim 10, comprising:
a jacking pin member, comprising a jacking seat and a plurality of jacking pins disposed on the jacking seat and corresponding to the respective ring bodies of the focus ring, wherein clearances between the jacking pins and the respective ring bodies increase in arithmetic progression according to an arrangement order of the respective ring bodies from top to bottom within the focus ring; and
a driving module drivingly connected to the jacking seat through a transmission rod to drive the jacking seat to move in both directions along an axial direction of the focus ring.

18. The focus-ring jacking structure according to any one of claims 11 to 17, wherein the transmission rod comprises a rod body, a fixed flange and a bellows, the fixed flange is configured to be fixedly connected to etch equipment in a sealing manner, the rod body extends through the fixed flange and is drivingly connected to the jacking pin member, and both ends of the bellows are respectively connected to the fixed flange and a bottom seat of the rod body in a sealing manner.

19. The focus-ring jacking structure according to any one of claims 11 to 17, wherein the jacking pins are arranged circumferentially around an axis of the focus ring and are spaced apart from each other.

20. The focus-ring jacking structure according to any one of claims 11 to 17, wherein
the driving module is a piston cylinder; or,
the driving module is a linear motor; or,
the driving module comprises a rotary motor and a transmission component.

21. The focus-ring jacking structure according to any one of claims 11 to 17, further comprising positioning sleeve shafts configured to be fixedly connected to etch equipment and to guide and position the respective jacking pins.

22. Etch equipment, comprising:
the focus ring according to any one of claims 1 to 9; and
the focus-ring jacking structure according to any one of claims 10 to 21.

23. A plasma etching device, comprising the etch equipment according to claim 22.
